# EUROPEAN PATENT APPLICATION

(11) **EP 1 160 858 A2**
(43) Date of publication of application: **05.12.2001**
(21) Application number: 01302530.9
(22) Date of filing: 20.03.2001
(51) Int. Cl.: H01L 23/31, H01L 21/56, H01L 21/68

(54) **A board for manufacturing a bga and method of manufacturing semiconductor device using thereof**

(30) Priority: 24.05.2000 JP 2000152429
(71) Applicant: SANYO ELECTRIC CO., LTD., Moriguchi-shi, Osaka (JP)
(72) Inventor: Sakamoto, Noriaki, Yamada-gun, Gunma (JP); Kobayashi, Yoshiyuki, Oura-gun, Gunma (JP); Sakamoto, Junji, Ota-shi, Gunma (JP); Mashimo, Shigeaki, Seta-gun, Gunma (JP); Okawa, Katsumi, Ota-shi, Gunma (JP); Maehara, Eiju, Kiryu-shi, Gunma (JP); Takahashi, Kouji, Sawa-gun, Gunma (JP)
(74) Representative: Nicholls, Michael John

(57) **Abstract**

By forming a flat member 10 forming a conductive film 11 having substantially same pattern with a second bonding pad 17, a wiring 18, and an electrode 19 for taking out , or forming a flat member 30 half-etched through the conductive film 11, it is possible to manufacture a semiconductor device 23 of BGA structure using a back process of a semiconductor maker.

## Description

### Background of the Invention

### 1.Field of the Invention

THE PRESENT INVENTION RELATES A BOARD FOR MANUFACTURING A BGA (Ball Grid Array) and method for manufacturing a semiconductor device using thereof .

### 2. Description of the related Art

In recent years, use of IC package for portable equipment or small, hi-density mounting equipment progresses, and the conventional IC package and its concept of mounting are largely changing. These details are described in *CSP technology, and mounting material and device supporting the technology -* special issue of DENSHI ZAIRYO (p.22, Set. 1998).

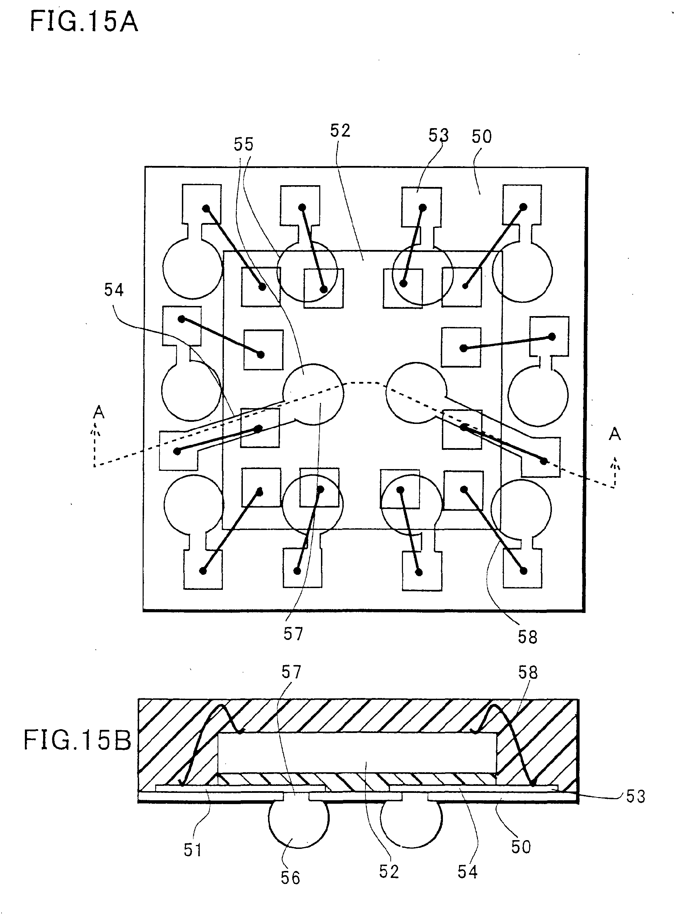

Fig. 15 relates to BGA using a flexible sheet 50 as an inter-poser board, Fig. 15A is a plan view, and Fig. 15B is a section view cut at A-A line.

On the flexible sheet 50, a copper foil pattern 51 is bonded through adhesive. On the flexible sheet 50, an IC chip 52 is fixed and a bonding pat 53 is formed around the IC chip 52 with said copper foil. A solder-ball connecting pad 55 is formed through a wiring 54 formed in one body with the bonding pad 53, and on the solder-ball connecting pad 55, a solder-ball is formed.

In Fig. 15A, the flexible sheet 50 is shown with a solid line of outside, and a rectangle of heavy line is the IC chip 52. As clear from the figure, at inside of the bonding pads 53 formed around the IC chip 52, the solder-ball connecting pads 55 are formed dispersedly in matrix-shape.

At rear side of the solder-ball connecting pads 55, an opening portion 57 is formed by processing the flexible sheet 50, and the solder-ball 56 is formed through the opening portion 57.

The above-described flexible sheet 50 is used as a board as same as ceramic board and printed board, and a member processed most thinly among these boards. However the price of the flexible sheet is expensive in comparison with the price of the ceramic board and printed board, and moreover there is a problem that cost of BGA substantially rises including a cost for machining the opening portion 57.

Thin type and lightweight are desired for a semiconductor device mounted for portable equipment and also for the above-described BGA. However considering process forming Cu foil pattern, process mounting the IC chip 52, and process bonding wire 58, the flexible sheet 50 is a member necessarily used for a supporting board, so it is impossible not to use the flexible sheet 50 considering manufacturing process.

Moreover there is a problem that the Cu foil pattern deforms or peels off because the Cu foil pattern is bonded with adhesive on the flexible sheet 50. As numbers of pad of the IC chip 52 increases year and year, making the Cu foil pattern fine is needed for realization with the BGA. Because of that, bonding area of the wiring 54 and bonding pad 53 decreases, thereby the Cu foil pattern deforms or comes off.

Furthermore there is a problem that manufacturing BGA takes much time because a semiconductor maker informs a flexible sheet maker of designated pattern data, the flexible sheet maker manufactures flexible sheet patterning, and the semiconductor maker purchases the completed flexible sheet. Accordingly it takes for a long time to accomplish a semiconductor device as a product for user. The semiconductor maker can not deliver said BGA to user in short time.

There is a problem that radiation of heat of the IC chip 52 is bad because of the flexible sheet 50 interposed between said Cu foil pattern 51 and IC chip 52.

### SUMMARY OF THE INVENTION

The present invention carried out in the view of the above-mentioned problems is, first, a board for manufacturing BGA, having a first face comprising a flat face and a second face formed facing to said first face, comprising a flat face. On said second face, a first conductive film having substantially same pattern as a bonding pad provided at periphery of a semiconductor element mounting area, a wiring extended to said semiconductor element mounting area in one body with the bonding pad, and an electrode for taking out formed in one body with the wiring is formed. The above formation solves the problem.

Second, the invention is a flat member having a first face comprising a flat face and a second face formed facing to said first face, comprising a flat face. On said second face, a photo resist having substantially same pattern as a bonding pad formed at periphery of semiconductor element mounting area, a wiring extended to said semiconductor element mounting area in one body with the bonding pad, and an electrode for taking out formed in one body with the wiring is formed. The above formation solves the problem.

Third, at area corresponding to said bonding pad, a conductive film conductive film is formed, and forming said photo resist so as to cover the film solves the problem.

By half-etching through conductive film or photo resist formed on the flat board, a conductive pattern supported with the flat member is formed. Therefore semiconductor makers can manufacture for oneself consistently from the flat member to semiconductor device by having an etching facilities.

As the flat member is used as a supporting board in fixing semiconductor element, electric connection using bonding wire, and sealing process using insulating resin, conventional flexible sheet as a supporting board is not need. Although the bonding pad is thin and exists in island-shape, and the wiring is arranged in unstable state because of its length and thinness, deformation such as bend or peeling is removed because of one body with the flat member.

By half-etching that pattern of the flat member is not removed from face to back by press or etching and the process is stopped on its way, interval between the conductive patterns can be made narrow so that finer pattern can be formed. Further separation of the pad and the wiring is possible by polishing or etching the back of the flat member after entirely fixing by sealing with an insulating resin, the pattern is arranged in designated position without gap and deformation even in the state of long wiring taken around.

In case of half-etching the photo resist as a mask, wire bonding is easily realized at the next process by remaining conductive film at the bonding pad.

Forth, the problem is solved by forming a pattern as substantially same as a guide pin or a guide hole where said guides pin is inserted at side parts of said flat member facing each other so that die mounting of said flat member is carried out in high accuracy at molding.

Fifth, the problem is solved by said flat member comprises a conductive foil and said conductive film comprises material different from said conductive foil.

By forming the conductive film, side face of the projection is made bent and further eaves are formed at the conductive film itself. Therefore a bonding pad and wiring being conductive pattern are buried in insulating resin with anchor effect.

Sixth, the invention is a flat member having a first face comprising a flat face and a second face having a projection formed in desired height and being formed facing to said first face. On said projection, a bonding pad provided at periphery of semiconductor element mounting area, a wiring extended to said semiconductor element mounting area in one body with the bonding pad, and an electrode for taking out provided in one body with the wiring are formed. The above formation solves the problem.

Seventh, forming a conductive film at surface of said projection solves the problem.

Eighth, providing a conductive film at least at area corresponding said bonding pad solves the problem

Ninth, the problem is solved by said flat member comprises a conductive foil and said conductive film comprises material different from said conductive foil.

In the flat member constructed at the projection, mounting semiconductor, electric connection to the pad, sealing, and so on are possible with facilities of later process of semiconductor maker. Therefore it is possible that a flat member is applied by a material maker and the semiconductor maker manufactures semiconductor device of BGA type.

Further, the flat member can be transferred more easily without positioning shift and can obtain a good bonding ability.

As the flat member is used as a supporting board in fixing semiconductor element, electric connection using bonding wire, and sealing process using insulating resin, conventional flexible sheet is removed. Although the bonding pad exists in island-shape, and is arranged in unstable state, deformation such as bend or peeling is removed because of one body with the flat member. Although bend or peeling appears because of long extended wiring, the bonding pad is in one body with the flat member so as to solve the problem.

Because of, interval between the pads or the conductive patterns is made narrow so that thinner pattern is formed. Further separation of pad, die pad, and the wiring is possible by polishing or etching the back of the flat member after entirely fixing by sealing with insulating resin, the pattern is arranged in designated position without gap.

Tenth, forming a projection of a pattern as substantially same as a guide pin or guides hole where said guide pin is inserted solves the problem.

Eleventh, arranging the designated pattern comprising said projection in matrix shape at said flat member solves the problem so that mass production is possible.

Twelfth, it solves the problem that said flat member comprises Cu, AL, Fe-Ni alloy, layered product of Cu-AL, or layered product of Al-Cu-Al.

Thirteenth, it solves the problem that a side face of said projection has anchor structure.

Fourteenth, it solves the problem that said conductive film provides eaves at upper face of said projection.

Fifteenth, according to using said conductive film made of at least one of Ni, Au, Ag, and Pd, said conductive film has anchor effect, and at the same time wire bonding and die bonding are possible. Sixteenth, the invention is a flat member having a entire flat back face corresponding to resin sealing area and a front face having a projection at an area surrounded with an upper die and a contacting area. The projection has a bonding pad provided at periphery of a semiconductor element mounting area, a wiring extended to said semiconductor element mounting area in one body with the bonding pad, and an electrode for taking out provided in one body with the wiring. It solves the problem that at least area surrounded with contacting area with said upper die constructs sealing space with said surface and said upper die.

Seventeenth, the invention is a flat member having a entire flat back face corresponding to resin sealing area and a front face having a projection. The projection has a bonding pad provided in an area surrounded with a contacting area to upper die, a wiring extended to said semiconductor element mounting area in one body with the bonding pad, and an electrode for taking out provided in one body with the wiring.

It solves the problem that the invention has process mounting a semiconductor at said semiconductor mounting area and electrically connecting said bonding pad and said semiconductor element, process mounting said flat member on a die and filling resin into the space constructed with said flat member and said upper die, and process separating said projections respectively removing the flat member exposing at the back face of said resin fill into.

Eighteenth, the invention is a method for manufacturing a semiconductor device according to Claim 17 characterized in that all of the back face of said flat member corresponding to said resin-sealing area contacts a lower die.

Nineteenth, it solves the problem that contacting area of said lower die is arranged scattering vacuum suction means.

Twentieth, said dividing step comprises a step of etching an entire surface of the flat member to a predetermined depth.

Twenty-First, said dividing step comprises a step of grinding an entire surface of the flat member so as to expose said resin.

Twenty-Second, said dividing step comprises a step of etching and grinding the flat member so as to expose said resin.

As the flat member is formed in sheet shape, the back face of the flat member is contacted in all face of the lower die, moreover conductive pattern such as pad and so on does not make any burr thereof at the back face of the flat member because that the conductive pattern is arrange in said sealing space.

As mentioned, the invention is constructed with conductive pattern, semiconductor element, and insulating resin sealing these and removes a flexible sheet so as to realize thin, light semiconductor device. Moreover by burying a wiring and forming a conductive film on surface of conductive foil, a bonding pat or a wiring having eaves at face thereof is formed and anchor effect appears so as to realize a semiconductor device of BGA type depressing deformation such as bend, lack, and so on of conductive pattern.

### Brief Description of the Drawings

[Fig. 1]

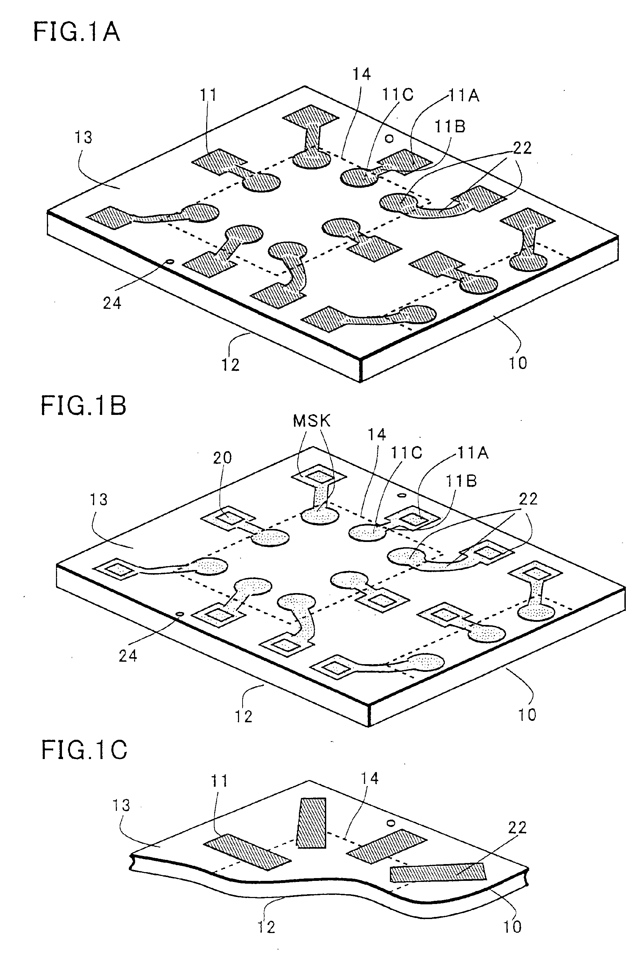

   Fig. 1 is a view describing the flat member of the invention.
[Fig. 2]

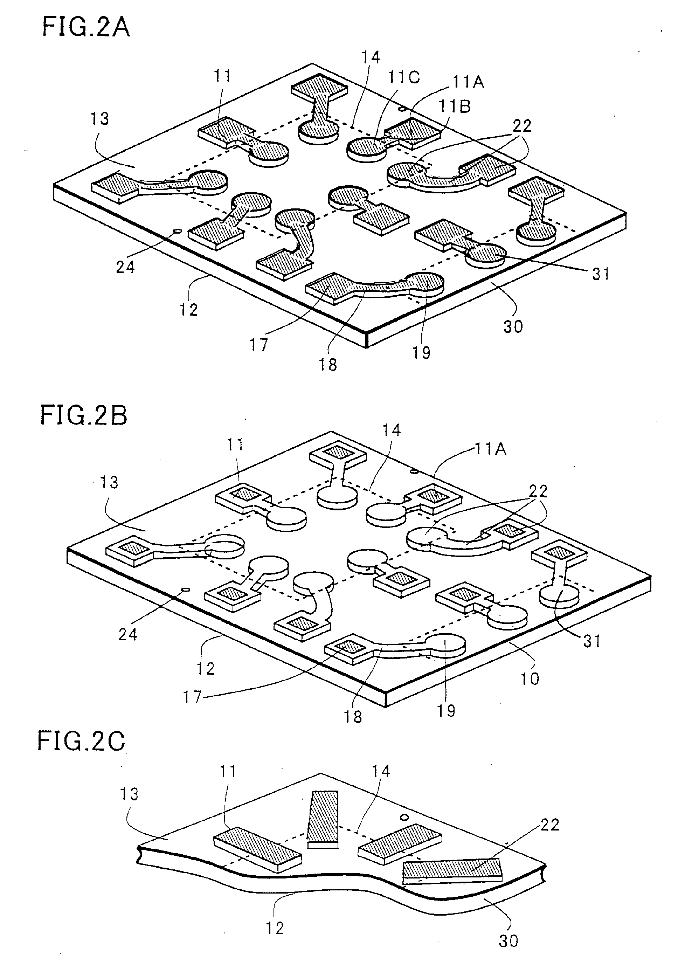

   Fig. 2 is a view describing the flat member of the invention.
[Fig. 3]

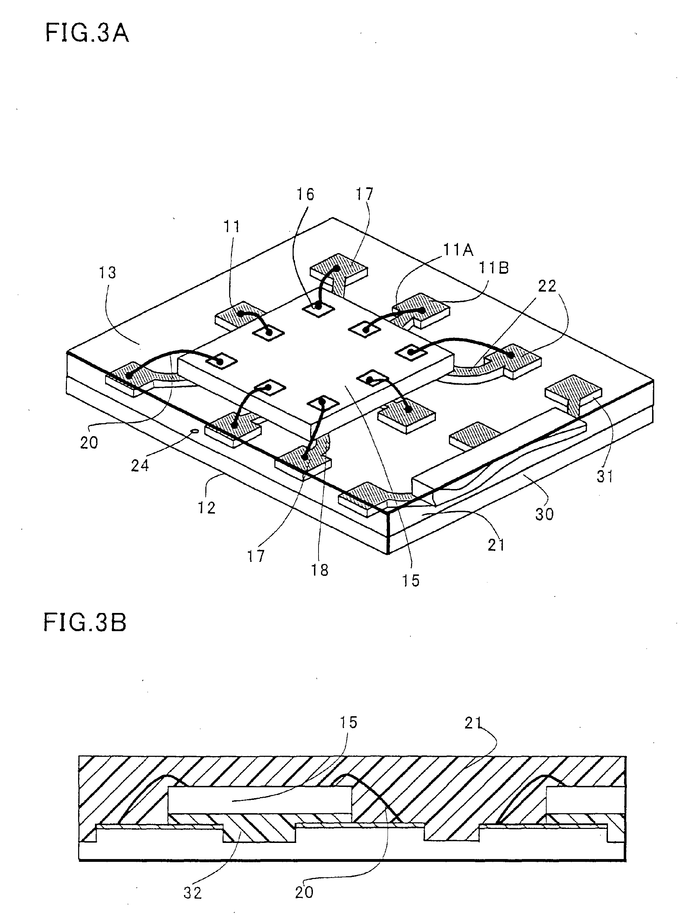

   Fig. 3 is a view describing the method for manufacturing the semiconductor device adopting the flat member of the invention.
[Fig. 4]

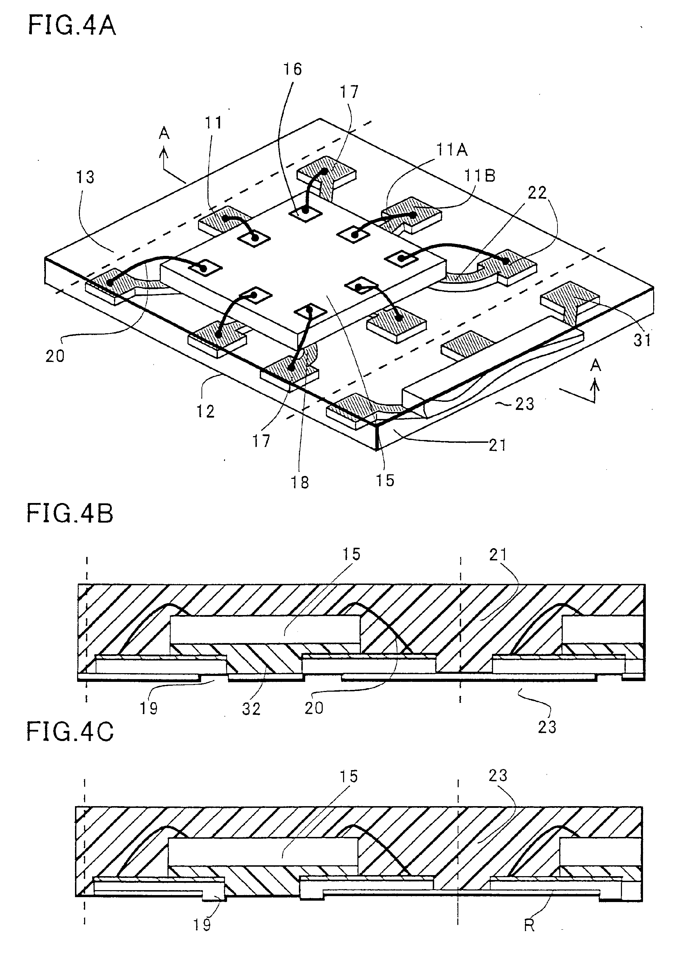

   Fig. 4 is a view describing the method for manufacturing the semiconductor device adopting the flat member of the invention.
[Fig. 5]

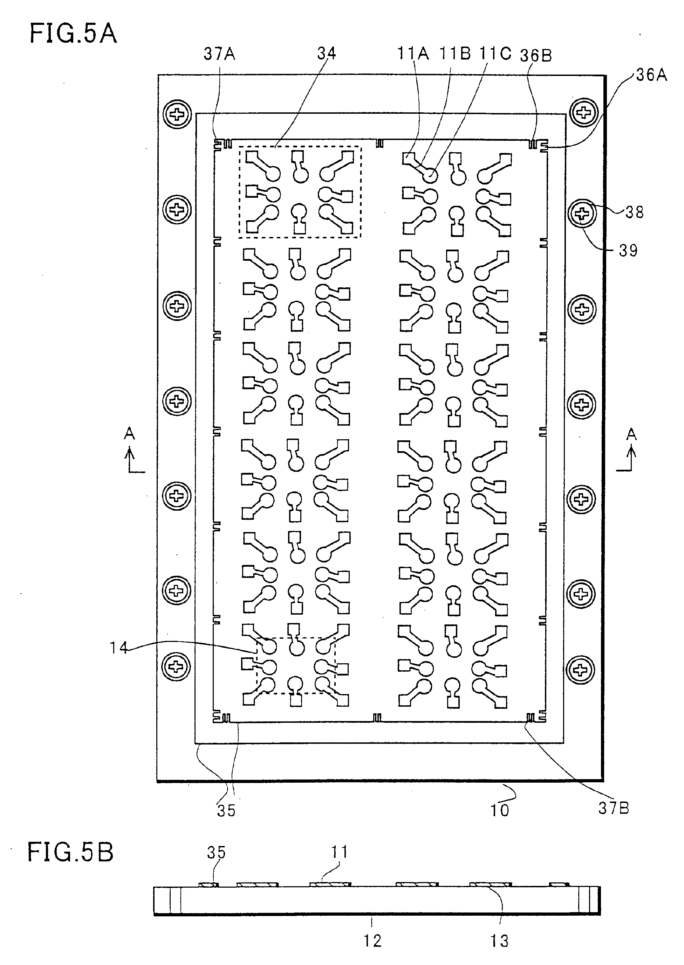

   Fig. 5 is a view describing the flat member of the invention.
[Fig. 6]

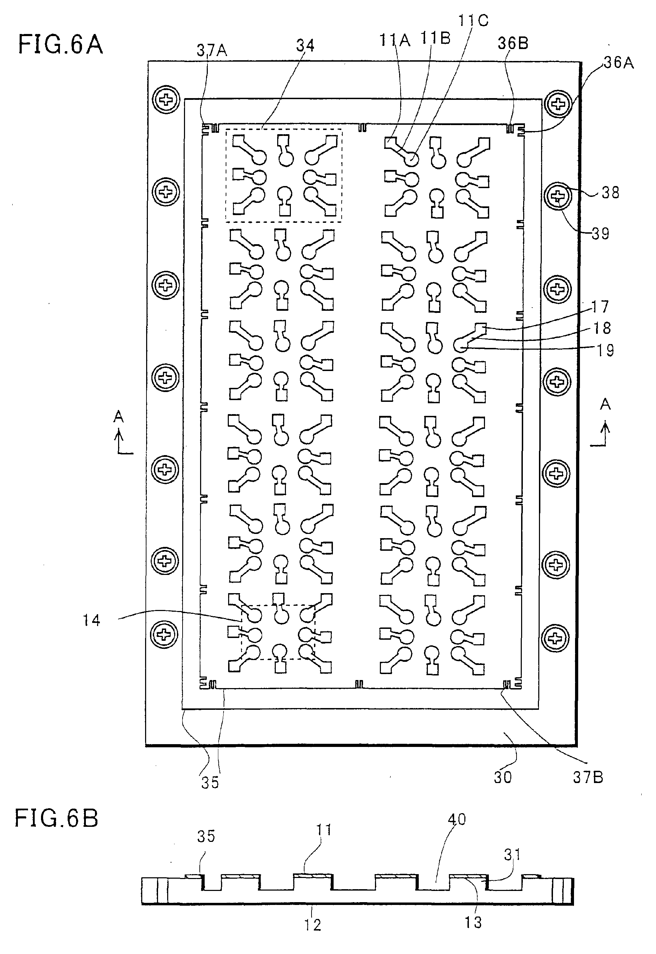

   Fig. 6 is a view describing the flat member of the invention.
[Fig. 7]

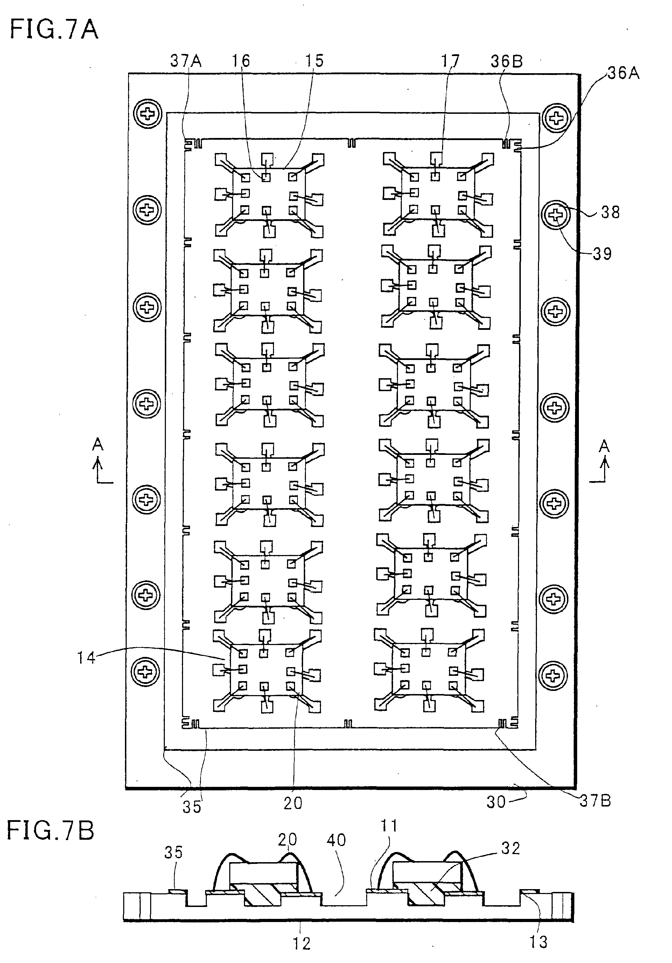

   Fig. 7 is a view describing the method for manufacturing the semiconductor device adopting the flat member of the invention.
[Fig. 8]

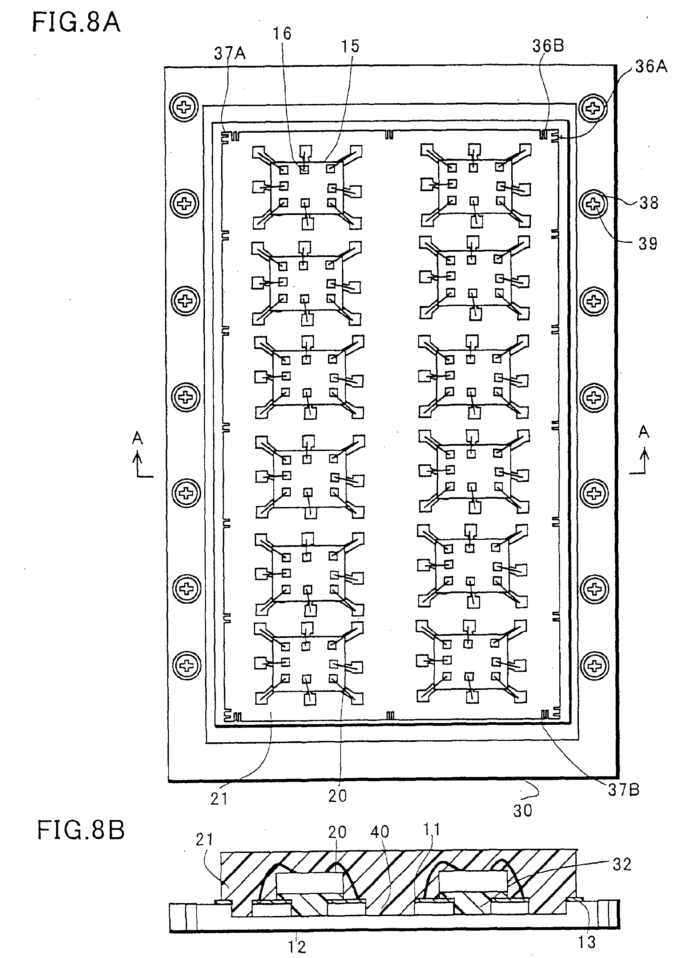

   Fig. 8 is a view describing the method for manufacturing the semiconductor device adopting the flat member of the invention.
[Fig. 9]

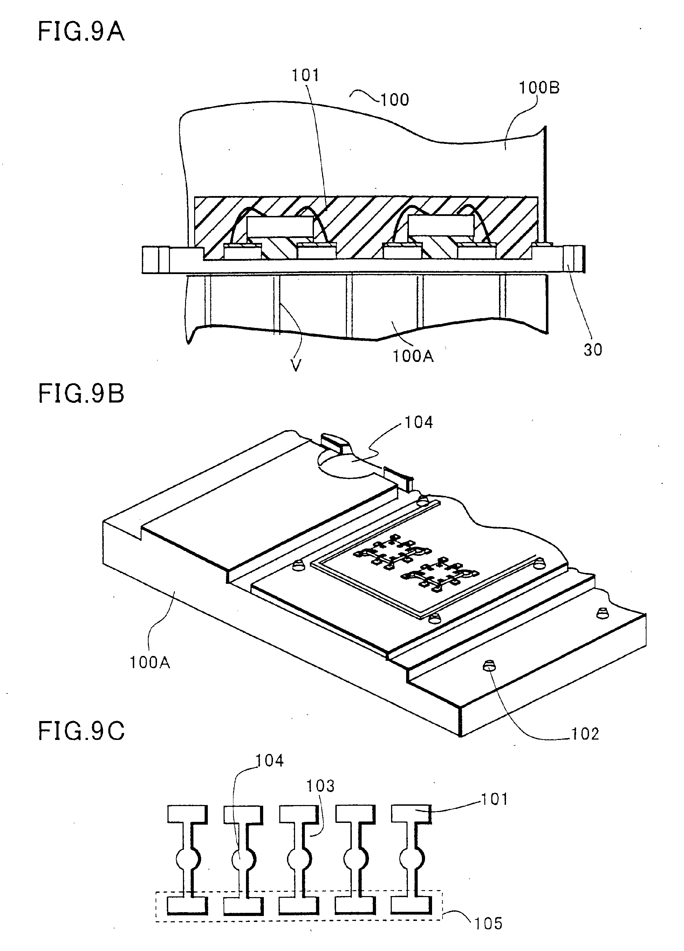

   Fig. 9 is a view describing the method for manufacturing the semiconductor device adopting the flat member of the invention.
[Fig. 10]

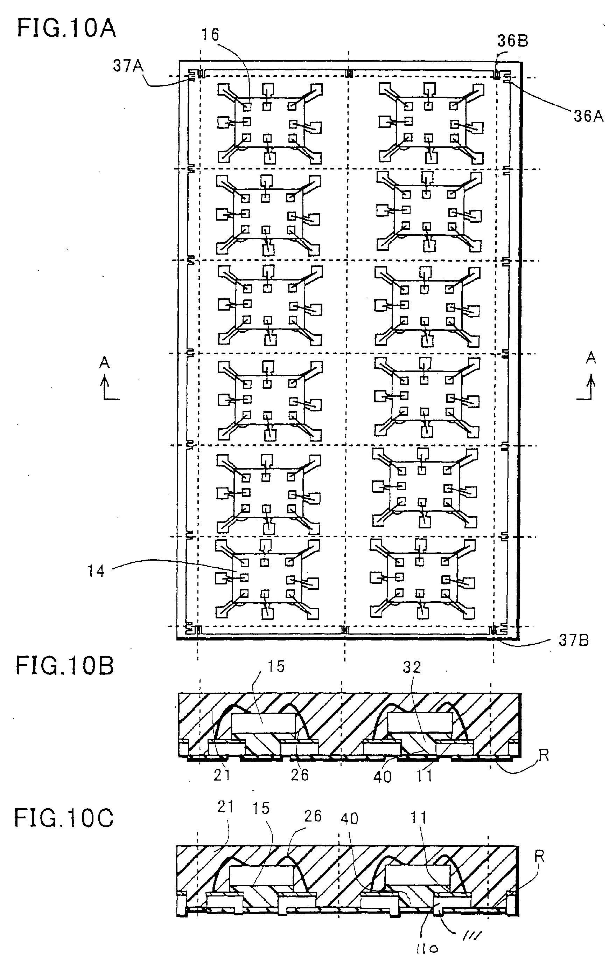

   Fig. 10 is a view describing the method for manufacturing the semiconductor device adopting the flat member of the invention.
[Fig. 11]

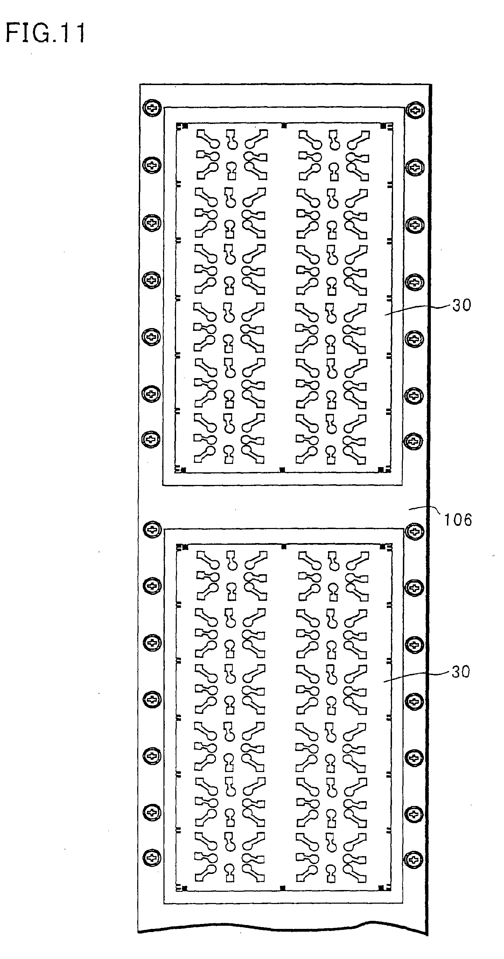

   Fig. 11 is a view showing the flat member adopted as a lead frame.
[Fig. 12]

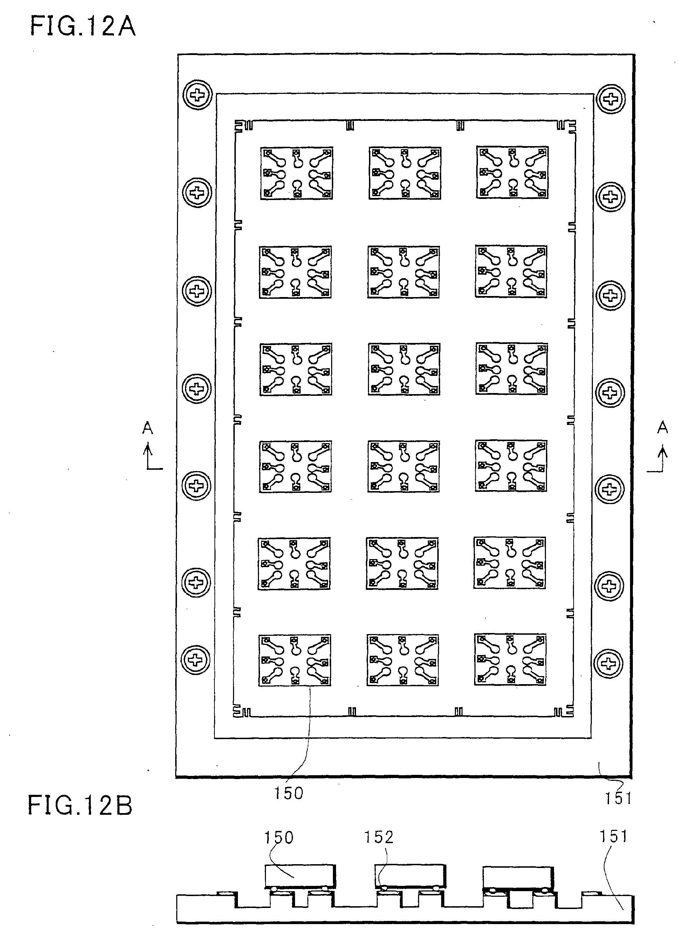

   Fig. 12 is a view describing the method for manufacturing the semiconductor device adopting the flat member of the invention.
[Fig. 13]

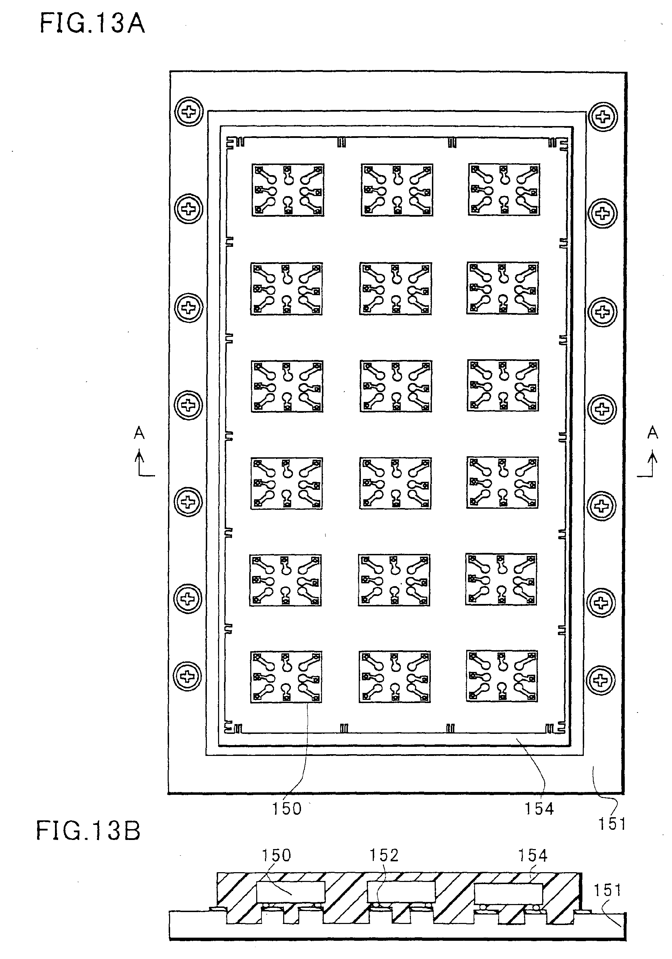

   Fig. 13 is a view describing the method for manufacturing the semiconductor device adopting the flat member of the invention.
[Fig. 14]

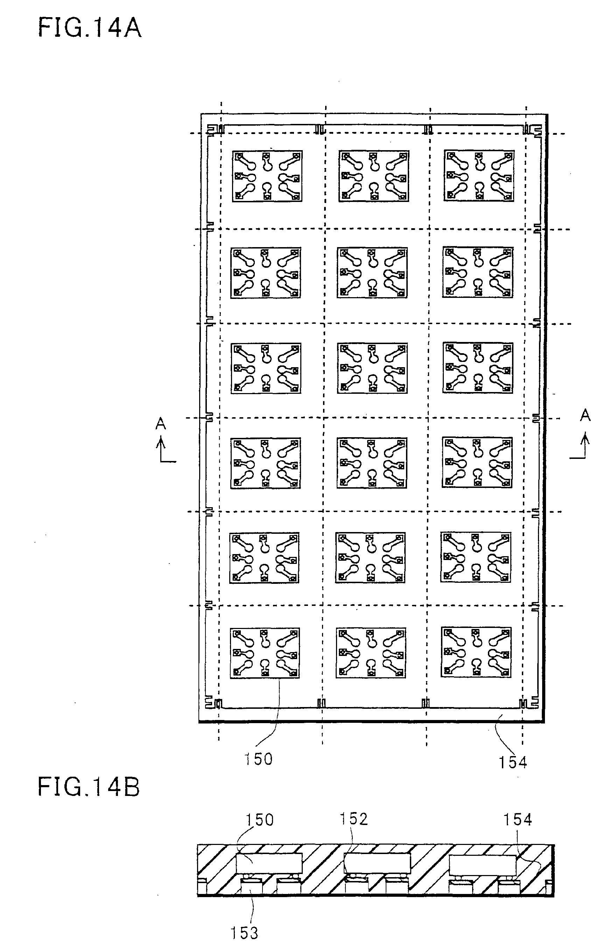

   Fig. 14 is a view describing the method for manufacturing the semiconductor device adopting the flat member of the invention.
[Fig. 15]
   Fig. 15 is a view describing the conventional semiconductor device of BGA structure.
   - 10: Flat member
   - 11: Conductive film
   - 12: First face
   - 13: Second face
   - 14: Semiconductor element mounting area
   - 15: Semiconductor element
   - 16: First bonding pad
   - 17: Second bonding pad
   - 18: Wiring
   - 19: Electrode for taking out
   - 20: Bonding wire
   - 21: Insulating resin
   - 22: Conductive pattern
   - 23: Semiconductor device

### Description of the preferred embodiments

The invention relates a semiconductor device arranged bonding pads at periphery of a semiconductor chip and electrodes for taking out in matrix-shape using wirings of one body with the bonding pads. Although it is generally called BGA that a solder ball is attached at the electrode for taking out, it is called a semiconductor device of BGA construction here including fixing by usual soldering.

### First embodiment

Fig. 1A shows a flat member which is advanced in effect than BGA so that thinner package is realized, than that of the package using the conventional flexible sheet.

In the flat member 10, a conductive pattern printed on the conventional flexible sheet in BGA is formed with a conductive film 11.

That is, the flat member 10 has a first face 12 comprising flat face and a second face 13 comprising flat face provide facing said first face 12. On said second face 13, a first conductive film 11A as substantially same pattern as a second bonding pad 17 is formed at periphery of a semiconductor mounting area 14. The first conductive film 11A is provided corresponding to a first bonding pad 16 on a semiconductor element 15 shown in Fig. 3 and is formed in substantially same pattern as the second bonding pad 17. A wiring 18 provide in one body with the above-mentioned second bonding pad 17, a second conductive film 11B substantially same pattern with an electrode 19 for taking out, and a third conductive film 11C are formed. These conductive films 11A to 11C may comprise in same material or not. However for the conductive film s 11A to 11C, the material available for etching resist mask is selected as clear in later mentioned method for manufacturing, and for surface of the conductive film 11A, material in which bonding wire 20 comprising Au or Al is in use by ball bonding method or ultrasonic bonding method is selected.

As clear in description of Fig. 13, material in which brazing filler metal and conductive paste are fixed is selected for the conductive film 11A in case of using a facedown-type element (SMD) as the semiconductor element 15.

On the flat member 10, an etching resist mask MSK such as photo resist and so on may be formed instead of said conductive film 11 as Fig. 1B. In this case, a conductive film 20 is formed at part corresponding to at least the second bonding pad 17 so that bonding using bonding wire or facedown bonding is possible, and all patterns including the conductive film is covered by photo resist MSK.

Characteristic of the invention is in said flat member 10. As clear in later description, the flat member 10 is half-etched through the conductive film 11 or photo resist MSK thereof, the semiconductor 15 is mounted thereon, and is sealed by insulating resin 21. The flat member 10 exposing at the back face of the insulating resin 21 is processed by etching, grinding or polishing etc. till conductive pad 22 comprising the second bonding pad, the wiring 18, and the electrode 19 for taking out is separated. By adopting the method for manufacturing, the semiconductor device is constructed by three materials; the semiconductor element 15, a conductive pattern 22, the insulating resin 21 burying the semiconductor element 15 and the conductive pattern 22. The flat member 10 is functioned as a semiconductor device 23 of BGA finally.

The biggest characteristic of the structure is that the conductive film 11 or etching-resist mask MSK is formed on surface of the flat member 10 so as to half-etch.

Generally in etching, lateral direction etching advances with advance of longitudinal direction etching. For example in case of isotropic etching, this phenomenon appears so that depth of longitudinal direction etching and length of lateral direction etching are substantially same. In anisotropic etching, said lateral direction etching is carried out though length of lateral direction etching is very shorter than in case of isotropic etching.

For example in the semiconductor device with BGA structure shown in Fig. 15, in case of forming conductive patterns 53 to 55 on a flexible sheet 50, it is necessary to remove the patterns so as to pass through from face to back of bonded Cu foil. However interval of conductive patterns is etched even to lateral direction, interval of the conductive pattern 22 and adjacent conductive pattern thereto can not made smaller than certain limit value because of correlation with thickness of Cu foil so that forming of fine pattern is difficult. Even in case of realizing semiconductor device of BGA construction adopting etching-type lead frame, similar phenomenon appears. Even in case of removing the lead frame by press, thickness of the lead frame becomes minimum interval between leads of the lead frame so that fine pattern has limit.

However by forming the conductive film 11 or the etching-resist mask MSK and then half-etching in depth suitable for fine pattern forming, etching quantity of lateral direction is depressed so that finer conductive pattern 22 is realized.

When conductive film 11 such as Ni, Ag, Au, Pd, and so on as a conductive film is formed on the flat member 10 of thick ness of 2 oz. (70 *µ*m) and the film is etched till entirely passing through using a mask therefor, interval of the conductive pattern is substantially 70 *µ*m at the narrowest case. However by using the conductive film 11 as etching-resist mask and by etching the flat member 10 till depth of 35 *µ*m, interval of the conductive patterns can be processed till depth of 35 *µ*m. That is, two times mounting efficiency is realized. In this fine pattern, the finer pattern is possible as the shallower depth of half-etching to the flat member 10.

In the flat member 10 according to the invention, wet etching is desirable considering etching facilities, mass-productivity, and manufacturing cost. However wet etching is non-anisotropic and etching of lateral direction is comparatively great in quantity. Therefore half-etching using the conductive film 11 and the etching-resist mask MSK is superior for finer conductive pattern 22.

In the flat member 10 of the invention, the conductive pattern 22 does not slip and bend as long as the flat member 10 is fixed because the half-etched conductive pattern 22 is in one body with the flat member 10. The flat member has characteristic that bonding to the second bonding pad 17 is stable.

Although it is need to support the conductive pattern with hanging lead in the semiconductor device with BGA structure forming the above-mentioned lead frame, it is not need in the invention. Therefore the conductive pattern 22 is arranged at any position without considering crossing the hanging lead so that design of the conductive pattern 22 becomes easy.

It is convenient to provide a guide hole 24 at the time of mounting the flat member 10 on a die.

The guide hole 24 may be opened before molding by drill, punching, or etching along the pattern patterned in a round shape at corresponding position with substantially same shape as a guide pin by conductive film or photo resist. The guide hole may be previously opened. Inserting the guide pin of the die into the guide hole 24 makes molding of high position accuracy possible.

As above-mentioned, the conductive pattern 22 appears by half-etching through the conductive film 11 or the etching-resist mask MSK, and this is possible to adopt as the conventional flexible sheet or the conventional lead frame.

A semiconductor maker generally has'plants for front process and back process (back-end process) separately, and in the back process molding adopting the flat member 10, generally etching facilities are not set up. Therefore the semiconductor maker can manufacture a semiconductor device 23 of BGA construction using the flat member by setting up film-making facilities of the conductive film 11 and etching facilities and by purchasing the flat member 10 where the conductive film 11 or the etching-resist mask MSK is formed from a metal material maker manufacturing lead frame.

The conductive pattern 22 may be a shape such as wiring having substantially constant width from an end to other end as shown in Fig. 1C. Although the pad 11A and the electrode 11C of Fig. 1A and Fig. 1B are rectangular and circle respectively, the shape is optional.

### Second mode for carrying out describing the flat member

The flat member 30 is half-etched through said conductive film 11 or etching-resist mask MSK, and a conductive pattern 22 is formed in projection shape.

That is, a flat member 30 has a first face 12 comprising a flat face and a second face 13 having a projection 31 formed in desired height and being formed facing to said first face 12, and said projection 31 comprises a second bonding pad 17 provided at periphery of semiconductor element mounting area 14, a wiring 18 of one body with the second bonding pad, and an electrode 19 for taking out provided in one body with the wiring.

The flat member 30 is substantially as same construction and same effect of the flat member 10 described in the first mode for carrying out. Difference is a point that the conductive pattern is half-etched.

Therefore a half-etching process will be described here. That is, a semiconductor maker, particularly in back process, does not have plating facilities of a flat member 10 comprising Cu and lithography facilities such as etching and so on. Therefore by purchasing the flat member 30 having the conductive pattern 22 comprising the projection using half-etching, the flat member 30 can be handled as same as the conventional lead frame so that it is possible to manufacture the semiconductor device 23 of BGA construction with existing facilities of the back process.

The conductive pattern 22 comprising the projection can be made by pressing the flat member 10. In case of the press, it is need to make the first face 12 flat if necessary by polishing or grinding because the first face 12 projects.

Third mode for carrying out describing a method for manufacturing semiconductor device adopting the flat member

Manufacturing the semiconductor device 23 with BGA structure using the above-mentioned flat member 10 or 30 is described referring Fig. 1 to Fig. 4. Fig. 2A shows the flat member 10 of Fig. 1A half-etched, and Fig. 2B shows the flat member 10 of Fig. 1B half-etched. Fig. 2C shows the flat member 10 of Fig. 1C half-etched. After Fig. 3, the flat member is described assuming that it is manufactured like Fig. 1A and Fig. 2A.

First a flat member 10 is provided. In the flat member 10, the first face 12 and the second face 13 are flat, and an etching-resist mask MSK of a conductive film 11 or a photo resist shaping into a conductive patternconductive pattern 22 are formed on the second face 13. In Fig. 1A, the conductive film 11 is formed on all face of the conductive pattern 22, which is hatched with diagonal lines. In Fig. 1B, a photo resist MSK is used instead of the conductive film 11 and covers a conductive film 11A formed at part corresponding to at least a second bonding pad 17. The photo resist MSK is hatched with dots. (Refer Fig. 1 about the above.)

Next the flat member 10 is half-etched through said conductive film 11 or the photo resist MSK. Depth of etching is shallower than thickness of the flat member 10. The shallower depth of etching, the forming of fine pattern is possible.

By half-etching, the conductive pattern 22 appears in projection shape on the second face 13 of the flat member 10 as Fig. 2. The flat member 10 may be made of Cu material, Al material, Fe-Ni alloy material, layered product of Cu-Al, or layered product of Al-Cu-Al. Particularly layered product of Al-Cu-Al can prevent bend generating by difference of coefficient of thermal expansion.

For example, by purchasing the flat member 10 of Fig. 1 from a frame maker if a semiconductor maker has etching facilities at the back process, and by purchasing the flat member 30 which the conductive pattern thereof is half-etched in projection shape if the semiconductor maker does not have etching facilities, the process can be moved to next process. (Refer Fig. 2 about the above.)

Next, a semiconductor element 15 is fixed at a semiconductor mounting area 14, and a first bonding pad 16 of the semiconductor element 15 and a second bonding pad 17 are electrically connected. In the figure, a bonding wire 20 is used for connecting means because the semiconductor element 15 is mounted in face-up type. In case of facedown type mounting, solder bump, brazing material such as solder ball, conductive paste such as Ag and Au, conductive ball, or anisotropic conductive resin is considered for connecting means.

In this bonding, the second bonding pad 17 is in one body with the flat member 30, moreover the back face of the flat member 30 is flat. Because of that, the flat member 30 is face-contacted to a table of a bonding machine. Therefore by entirely fixing the flat member 30 on the bonding table, without causing the second bonding pad 17 deviated, bonding energy can be transferred to the bonding wire 20 and the second bonding pad 17 so that connecting strength of the bonding wire 20 is improved. Fixing of bonding table is possible by providing a plural of vacuum suction holes V at all the table like Fig. 9 for example.

For fixing the semiconductor element 15 and the flat member 30, insulating adhesive 32 is used, and considering radiation, filler such as Si oxide, Al oxide, and so on may be mixed the insulating adhesive 32.

Then an insulating resin 21 is formed so as to cover said conductive pattern, the semiconductor element 57, and connecting means.

For example in case of sealing using a die, a guide hole 24 is provided on the flat board, and a guide pin of the die is inserted into the hole. Because the first face 12 of the flat member 30 is flat, face of lower die is formed flat. Any of thermal plasticity and thermohardening is used for the insulating resin 21.

The molding is realized by transfer molding, injection molding, dipping, and painting realize. As resin material, thermohardening resin such as epoxy resin etc. is used for transfer molding, and thermal plasticity resin such as liquid crystal polymer, polyphenylenesulfide, and so on is used for injection molding.

In the mode for carrying out, thickness of insulating resin 21 is adjusted so that upper part from top portion of the bonding wire 20, is about 100 *µ*m, is covered. This thickness is possible to make thick or thin considering strength of the semiconductor device 23.

In filling, position shift of the conductive pattern 22 as long as the flat member 30 does not shift because the conductive pattern is formed in one body with the flat member 30. Fixing the lower die and the back face of the flat member 30 is realized by vacuum suction. A depressing pin provided at the die may be used.

As the above, in the insulating resin 21, the conductive pattern 22 formed as the projection 31 and the semiconductor element 15 are buried, and the flat member 30 of lower part than the projection 31 exposes from the back face of the insulating resin. (Refer Fig. 3 about the above.)

Next, the flat member 30 exposing at the back face of said insulating resin 21 is removed, and the conductive pattern 22 is separated individually.

A various methods are considered for the separating process, that is, the back face may be removed by any of etching and polishing or grinding. Both of them are available. For example, there is a problem that scraped chip of the flat member 30 and burr-shape metal extended thin to outside encroaches on the insulating resin 21 so as to be thinner. Because of that, grinding is stopped before the insulating resin 21 exposes, after that, by separating the conductive pattern 22 by etching, the conductive pattern is formed without encroaching of metal of the flat member 30 on the insulating resin 21 positioned between the conductive patterns 22. That prevents a short between the conductive patterns 22 of fine interval.

In half-etching, dispersion of thickness appears on the insulating resin 21 between the conductive patterns 22 by dispersion of etching depth. After separating the conductive patterns 22 individually by etching method, Grinding can be conducted so as to be a predetermined thickness, therefore a package having a certain thickness can be formed.

In case that a plural of one unit being the semiconductor device 23 are formed, there is a dicing process as individual semiconductor device 23 after the separating process. The dicing line is shown with thick dotted line.

Although the semiconductor devices are separated individually using the dicing equipment, chocolate breaking, pressing, or cutting is possible.

The conductive pattern 22 exposing at the back face may be exposed at part corresponding to an electrode 19 for taking out as Fig. 4B. For the exposed electrode 19 for taking out, one of the connecting means such as fitting of conductive ball such as solder ball, covering of conductive paste such as brazing material such as solder or conductive paste such as Ag paste, anisotropic conductive resin is selected.

In Fig. 4C, etching is carried out through photo resist formed on the exposed electrode 19 for taking out, and the exposed electrode 19 for taking out is made projection shape. A conductive resin R is covered so that the exposed electrode 19 for taking out exposes.

By coating the insulting resin R at the back face as Fig. 4B and Fig. 4C,wiring of mounting board side can be passed at the lower layer. (Refer Fig. 4 about the above.) By the above-mentioned method of manufacturing, three elements of a plural of conductive patterns 22, the semiconductor element 15, and insulating resin 21 realizes a light, thin, short, small semiconductor device of BGA structure.

Next, effect generating by the above-mentioned method for manufacturing.

First, a flexible sheet used as a supporting board is removed because the conductive pattern 22 is half-etched and supported in one body with the flat member 30.

Second, making the conductive pattern 22 fine is possible because the conductive pattern 22 which is half-etched and has a projection is formed on the flat member 30. Therefore width of the conductive pattern 22 and interval between the conductive patterns 22 can be narrow so that smaller package in plane size is formed.

Third, because of construction of said three elements, the semiconductor device consists of the least necessary elements, and useless material is removed to the utmost so that a thin type semiconductor device 23 which is depressed largely in cost is realized.

Fourth, because the second bonding pad 17, the wiring 18 and the electrode 19 for taking out are formed in projection by half-etching, and separating individually is carried out after sealing, tie bar and hanging lead(support bar) used for lead frame are not need so that pattern design becomes easy.

Although only one semiconductor element is mounted in the semiconductor device of the BGA structure, a plural of semiconductor elements may be mounted.

### Fourth embodiment

Fig. 5 shows a flat member 10 where a conductive film 11 forms a conductive pattern 22 as same as the first mode for carrying out. An etching resist mask such as photo resist may be formed instead of the conductive film 11. In this case, a conductive film is formed at part corresponding to a bonding pad, and a photo resist pattern is formed so as to cover the conductive film.

The pattern shaping up the pattern of Fig. 1 is shown in Fig. 5. Concretely, pattern units 34 where conductive pattern surrounded by dotted line is one semiconductor are formed in matrix shape, and die contacting area 35 is formed in ring shape with designated width as surrounding the pattern units. That is, pattern of Fig. 5 shows the conductive pattern formed in one cavity.

At inside of the die contacting area 35, alignment marks 36 and 37 are provided. A line connecting alignment marks 36A and 37A shows dicing line of lateral direction, and a line connecting alignment marks 36B and 37B shows dicing line of longitudinal direction. Each alignment mark is formed at least one short straight line, and direction of blade of dicing equipment is adjusted making reference to the straight line. Here alignment mark is provided in the desired interval (margin) so that the blade is ground in desired accuracy, and consists of two straight lines.

Moreover at outside of said die-contacting area 35; a first pattern 38 and a second pattern 39 for forming a guide hole are formed. The cross of the second pattern 39 is a centering mark when forming the guide hole by drill. A guide hole same shape as the first pattern may be provided previously without forming the pattern.

AS above-mentioned, characteristic and effect of the mode for carrying out are omitted because these are same as the first mode for carrying out except the line mark of dicing line and the die contacting area 35.

### Fifth mode for carrying out describing a flat member

The flat member 30 has a shape shown in Fig. 6, and has a projection 31 half-etched through the etching-resist mask of the conductive film 11 or the photo resist shown in the fourth mode for carrying out. A first alignment mark 38 and a second alignment mark 39 may be formed in projection shape by half-etching.

The flat member 30 is handled similarly as the conventional lead frame, SIP, DIP, QIP, and so on for example.

That is, a flat member 30 has a first face 12 comprising a flat face and a second face 13 having a projection 31 formed in desired height and being formed facing to said first face 12, and said projection 31 comprises a second bonding pad 17 provided at periphery of semiconductor element mounting area, a wiring 18 of one body with the second bonding pad 17, and an electrode 19 for taking out 19 provided in one body with the wiring 18.

The flat member 30 is in the state that each pattern is half-etched, and it is possible to fix the semiconductor element, to connect electrically, and to seal so that manufacturing with existing facilities of the back process is possible.

As the effect is described in the first mode for carrying out and the fourth mode for carrying out, it is omitted here.

Six mode for carrying out describing a method for manufacturing a semiconductor device

Next, a method for manufacturing the semiconductor device is described referring Fig. 5 to Fig. 11.

First, a flat member 10 is provided as Fig. 5. Material for the flat member 10 is selected considering adhesion of brazing material, characteristic of bonding and plating characteristic. They are a conductive foil which is Cu as main material, a conductive foil which is Al as main material, a conductive foil of sheet shape comprising alloy of Fe-Ni, layered product of Cu-Al, and layered product of Al-Cu-Al. On the surface of the flat member 10, a second bonding pad 17, a wiring 18, an electrode 19 for taking out, a die contacting area 35, alignment marks 36 and 37, patterns 38 and 39 are formed by an etching-resist mask of a conductive film 11 or a photo resist.

It is desired that thickness of the conductive foil used for the flat member 10 is about 10 *µ*m to 300 *µ*m, here Cu foil of 70 *µ*m (2 oz.) is used. However fundamentally the thickness may be more than 300*µ*m or less than 10 *µ*m. (Refer to Fig. 5 about the above.)

Next, the flat member 10 is selectively removed except area providing the second bonding pad 17, the wiring 18, the electrode 19 for taking out, the die contacting area 35, the alignment marks 36 and 37, and patterns 38 and 39 so that the area is thinner than thickness of the flat member 10.

Here the conductive film 11 or the photo resist is used for an etching-resist mask, and said isolation groove 40 is formed shallower than thickness of the flat member 10.

In the method for manufacturing, the flat member is etched non-anisotropicaly by wet etching or dry etching, and has characteristic that the side thereof has coarse face and made bend.

In case of the wet etching, ferric chloride or cupric chloride is generally used for etchant, said conductive foil is dipped into the etchant or the etchant is showed.

Especially just under the conductive film 11 or photo resist being etching mask, etching of lateral direction is hard to advance and deeper part than the etching mask is etched to lateral direction. Because of that, the upper direction of the position goes from one side of the isolation groove 40, the smaller opening diameter of the opening corresponding to the position becomes, so that the opening has reverse-tapered structure having anchor structure. By using showering, etching is advance to depth direction and etching to lateral direction is depressed so that the anchor structure remarkably appears.

In the case of dry etching, both of anisotropic and non-anisotropic etchings can be used. Although it is said impossible to remove Cu by reactive ion etching nowadays, Cu is removed by spattering. Depending on the condition of the spattering, both of anisotropic and non anisotropic etchings are possible.

Material for the conductive film is Ni, Ag, Au, Pt, or the like. These corrosive resistant conductive film s have characteristic that they are used alone for a bonding pad.

For example, thin Au wire can be bonded to the conductive film of Ag and Au. Ni makes ultrasonic bonding with Al wire possible. Therefore, these conductive film s have a merit that they are used alone for a bonding pad.

Of course here, anisotropic etching may form the projection. (Refer Fig. 6 about the above.)

Next, there is a process mounting the semiconductor element 15 on the semiconductor element mounting area 14 as Fig. 7.

The semiconductor element 15 is a transistor, diode, IC chip, and the like. CSP of wafer-scale type and SMD (semiconductor element of facedown type) of BGA and the like can be mounted though thickness of them becomes thick.

Here a bare IC chip is fixed by insulating adhesive 32, and a first bonding pad 16 on the IC chip and a second bonding pad 17 are connected through a bonding wire 20 fixed by ball bonding using thermocompression bonding or wedge bonding using ultrasonic wave.

The bonding pad 17 shown in the figure is in one body with the flat member 30 though the size thereof is very small. Therefore energy of a bonding tool can transfer to the bonding pad 17 so that bonding ability is improved. There is a case to pull-cut a bonding wire at cutting the bonding wire after bonding. Because that the second bonding pad 17 is in one body with the flat member 30 in this case, phenomena that the bonding pad 17 rises is removed and pull-cutting ability is improved. (Refer Fig. 7 about the above.)

Moreover there is a process of applying an insulating resin 21 in an isolation groove 40 . This is realized by transfer molding, injection molding, dipping, or painting. As resin material, thermohardening resin such as epoxy resin etc. is used for transfer molding, and thermal plasticity resin such as liquid crystal polymer, polyphenylenesulfide, and so on is used for injection molding.

In the mode for carrying out, thickness of insulating resin 21 is adjusted so that upper part from top portion of the bonding wire 20, about 100 *µ*m, is covered. This thickness is possible to make thick or thin considering strength of the semiconductor device 23.

Characteristic of the process is that the flat member 30 functions as a supporting board till the insulating resin 21 is covered and hardened. Although a supporting board of a flexible sheet is need in the conventional BGA, the invention does not need.

Moreover, because the insulating resin 21 is filled in the isolation groove 40 having bending structure, anchor effect appears at this part so that said conductive pattern 22 is hard to peel off from the insulating resin 21.

Potting silicon resin and the like is useful in order to protect connecting portion the semiconductor chip and the bonding wire for example before covering the insulating resin 21.

Fig. 9 shows the molding method. Fig. 9A is a section view showing the state that the insulating resin 21 is filled into a cavity 101 in a die 100. It is clear that the back face of the flat member 30 contacts a lower die 100A and upper die 100B contacts at a die contacting area. The symbol V is a vacuum suction hole. Fig. 9B shows the state that the flat member 30 is mounted on the lower die 100A. Symbol 102 is a guide pin attached at the lower die 100A, and the guide pin appears through a guide hole opened at the flat member 30.

Fig. 9C is a view describing relation of a cavity 101, a runner 103, and a pot 104 formed at the die. As shown in the figure, the die is designed so that several cavities 101 are arranged to lateral direction and a lot of semiconductor devices are taken from one frame. Symbol 105 shown with dotted line shows arranging area of the flat member, and the flat member 106 like Fig. 11 for example is mounted with handling similar as the conventional lead frame. The flat member 30 as shown in Fig. 6 is formed by using the die where plural cavities and so on are made in one body. The semiconductor device manufactured with the flat member itself is small in size, and is possible to take a lot of devices in one cavity and to mass-product, so as to decrease manufacturing cost. (Refer to Fig. 8 and Fig. 9 about the above.)

Next, there is a process removing the flat member 30 exposing at the back face of the insulating resin 21 and separating the conductive pattern 22.

Fig. 10A is a plan view showing separating line, and Fig. 10B shows that the back face of the insulating resin 21 and the second bonding pad 17, or the back face of the insulating resin 21 and wiring 18 and the electrode 19 for taking out, are fit. This is possible by grinding off using polisher or grinder till the isolation groove 40 exposes . Only part needing electrical connection may be exposed from an insulating film such as solder resist and the like.

In Fig. 10C, a projection 111 is formed at other end 110 of the electrode 19 for taking out, by stopping the polishing on the way. This is possible by forming photo resist at part corresponding to the projection 111 and by etching part except this. The insulating film R is formed so that the projection 111 exposes. This process can prevent a short to conductive member of mounting board side passing under the semiconductor element 15.

Finally, the semiconductor device completes by arranging the molding member on a dicing table, adjusting position of a blade referring the alignment marks 36 and 37, and dicing along the line shown with the dotted line.

Seventh mode for carrying out describing a method for manufacturing a semiconductor device

Next, Fig. 12 to Fig. 14 show mounting a semiconductor element 150 of facedown type on a flat member 151 and manufacturing a semiconductor device of BGA structure.

Although a conductive pattern 22 is extended outer from semiconductor element mounting area by using a bonding wire 20, it is possible to make less or to remove the projection by adopting the facedown type. Although thickness of the package becomes thick because the top of the bonding wire 20 becomes high, thin type is possible by adopting the facedown type.

For the semiconductor element of facedown type, a solder ball 152, or bump of solder or Au instead of the solder ball is used.

In case of fixing the semiconductor element 150 with brazing material such as solder, it is not need to form the conductive film like the bonding pad because an electrode for taking out 153 consists of Cu as main material. However it needs for generating anchor effect making eaves.

As method for manufacturing is similar as said mode for carrying out, it is described simply.

A flat member 151 is providing as shown in Fig. 12, the solder ball 152 of the semiconductor element 150 is fixed on the flat member 151.

Next, the flat member is sealed using an insulating resin 154 as shown in Fig. 13.

Finally, the semiconductor device completes by separating the conductive pattern removing the flat member 151 positioning at the back face of the insulating resin 154 and by dicing along the line shown with the dotted line as shown in Fig. 14.

A part corresponding to the electrode for taking our may be exposed covering the insulating resin R on the back face of the package as Fig. 10B and Fig. 10C.

By covering a conductive film which is small in etching rate on the flat member and half-etching through the conductive film, eaves and bending structure are realized so as to have anchor effect. This is applicable for all modes for carrying out.

The method is suitable because Cu and Ni formed on the Cu are etched at the same time by ferric chloride or cupric chloride and eaves of Ni is formed by difference of etching rate.

As clear from the above description, the flat member of the invention has the structure half-etching the conductive pattern through the conductive film or the photo resist. Moreover the flat member can construct as the conductive pattern by stopping press or etching on the way without removing the flat member from front to back. The construction adopting the half-etching can make interval of the conductive pattern narrow so that the pattern for finer semiconductor device of BGA construction is possible. As the second bonding pad, the wiring, and the electrode for taking out are constructed in one body, deformation or bend is depressed. Moreover separating the conductive pattern is possible by polishing or etching the back face of the flat member after fixing entirely sealing the insulating resin so that the conductive pattern can be arranged at the designated position without position shift. Further the wiring necessary for the semiconductor device of BGA construction can be arranged without any deformation.

Arranging all of the conductive pattern area in the resin sealing area can remove burr generating from the conventional lead frame.

Forming the same pattern as the guide pin can open as the guide hole at sealing with the insulating resin. As the flat member is set on the guide pin of the die for sealing, resin sealing of high position accuracy is possible.

Constructing the flat member with Cu as main material and constructing the conductive film with Ni, Ag, Au or Pd can use the conductive film as an etching mask. Further when the flat member is half-etched, side thereof provides bending structure and eaves by the conductive film is formed at surface of the conductive pattern, and the flat member has the structure having anchor effect. Therefore removing and bend of the conductive pattern positioning at the back face of the insulating resin are prevented.

The semiconductor device manufactured at the flat member consists of the least necessary elements of the semiconductor element, the conductive pattern, and the insulating resin so that the semiconductor device is useful for resources. Therefore the semiconductor device extremely decreasing cost is realized. As the supporting board such as a flexible board is not used, heat resistance of the supporting board is removed so that radiation ability is improved. By making thickness of film of the insulating resin and thickness of the conductive foil optimum, the small, thin, and light semiconductor is realized.

Exposing from the insulating resin, the back face of the conductive pattern can instantly connect to outside so that process of through-hole such as the flexible sheet of the conventional structure is not need.

The semiconductor device has a structure having flat surface where the surface of the isolation groove and the surface of the conductive pattern are substantially same, and correction of shift of the electrode for taking out is extremely easy because the semiconductor device itself is moved just horizontally even if mounting the narrow pitch GFP on the mounting board.

Side face of the conductive pattern has bending structure, and eaves are formed at the front face. Therefore it is possible to generate anchor effect and to prevent bend and removing.

The flat member supports the entire device till the insulating resin is covered, and at separation and dicing of the conductive pattern, the insulating becomes a supporting board. Therefore the supporting board described in the prior art is removed, and the invention has a merit that the device is made low in cost.

## Claims

1. A board for manufacturing a BGA, comprising a first face of a flat face and a second face of a flat face facing to said first face,
wherein said second face forms a first conductive film having substantially same pattern as a bonding pad provided at periphery of semiconductor element mounting area, a wiring extended to said semiconductor element mounting area integrated with the bonding pad, and an electrode for taking out formed in one body with the wiring.

2. A board for manufacturing a BGA, comprising a first face of a flat face and a second face of a flat face facing to said first face,
wherein said second face forms a photo resist having substantially same pattern as a bonding pad provided at periphery of semiconductor element mounting area, a wiring extended to said semiconductor element mounting area integrated with the bonding pad, and an electrode for taking out formed in one body with the wiring.

3. A board for manufacturing a BGA according to Claim 2, wherein a conductive film is provided at area corresponding to said bonding pad and said photo resist is formed so as to cover the conductive film .

4. A board for manufacturing a BGA according to Claim 1, wherein a substantially same pattern as a guide pin or a guide hole where said guides pin is inserted is formed at side parts of said flat member facing each other.

5. A board for manufacturing a BGA according to Claim 1, wherein said flat member comprises a conductive foil and said conductive film comprises material different from said conductive foil.

6. Aboard for manufacturing a BGA comprising a first face of a flat face and a second face having a projection formed in desired height and facing to said first face,
wherein said projection is formed in an area corresponding to a bonding pad provided at periphery of a semiconductor element mounting area, a wiring extended to said semiconductor element mounting area integrated with the bonding pad, and an electrode integrated with the wiring.

7. A board for manufacturing a BGA according to Claim 6, wherein a conductive film is formed on surface of said projection.

8. A board for manufacturing a BGA according to Claim 7, wherein a conductive film is formed on at least an area corresponding to said bonding pad.

9. A board for manufacturing a BGA according to Claim 6 , wherein said flat member comprises a conductive foil and said conductive film comprises material different from said conductive foil.

10. A board for manufacturing a BGA according to Claim 6, wherein a substantially same pattern as a guide pin or a guide hole where said guides pin is inserted is formed at side parts of said flat member facing each other.

11. A board for manufacturing a BGA according to Claim 6, wherein a pattern of said projection is formed in a matrix manner.

12. A board for manufacturing a BGA according to Claim 6, wherein said flat member comprises Cu, Al, Fe-Ni alloy, layered product of Cu-Al, or layered product of Al-Cu-Al.

13. A board for manufacturing a BGA according to Claim 6, **characterized in that** side face of said projection has an anchor construction.

14. A board for manufacturing a BGA according to Claim 6, **characterized in that** said conductive film constructs eaves at an upper face of said projection.

15. A board for manufacturing a BGA according to Claim 14, wherein said conductive film is made of anyone of Ni, Au, Ag, and Pd.

16. A board for manufacturing a BGA having a entire flat back face corresponding to a resin sealing area and a front face having designated thickness from said back face formed in sheet shape, the front face forming a projection at an area surrounded with a contacting area to an upper die, the projection having a bonding pad provided at periphery of a semiconductor element mounting area, a wiring extended to said semiconductor element mounting area in one body with the bonding pad, and an electrode for taking out provided in one body with the wiring,
wherein at least an area surrounded with contacting area to said upper die constructs a sealing space with said front face and said upper die.

17. A method of manufacturing a semiconductor device comprising steps of:
preparing a board comprising a entire flat back face corresponding to a resin sealing area and a front face formed in sheet shape having designated thickness from said back face, the front face forming a projection, the projection having a bonding pad provided at an area surrounded with a contacting area to an upper die, a wiring extended to said semiconductor element mounting area integrated with the bonding pad, and an electrode for taking out provided in one body with the wiring;
mounting each of semiconductor chips at said semiconductor element mounting area to electrically connectsaid semiconductor element to said bonding pad ;
placing said board on a die;
filling resin into the space constructed with said flat member and said upper die; and
dividing into a plurality of devices so that said projections are separated respectively by removing the flat member exposed at the back face of said resin filled into.

18. A method for manufacturing a semiconductor device according to Claim 17, wherein the entire back face of said flat member corresponding to said resin-sealing area contacts a lower die.

19. A method for manufacturing a semiconductor device according to Claim 18, wherein that vacuum suction means is arranged separately at a contacting area of said lower die.

20. A method for manufacturing a semiconductor device according to Claim 17, wherein said dividing step comprises a step of etching an entire surface of the flat member to a predetermined depth.

21. A method for manufacturing a semiconductor device according to Claim 17, wherein said dividing step comprises a step of grinding an entire surface of the flat member so as to expose said resin.

22. A method for manufacturing a semiconductor device according to Claim 17, wherein said dividing step comprises a step of etching and a step of grinding of the flat member so as to expose said resin.
